# EUROPEAN PATENT SPECIFICATION

(11) **EP 2 408 275 B1**
(45) Date of publication and mention of the grant of the patent: **11.01.2017**
(21) Application number: 10750873.1
(22) Date of filing: 10.03.2010
(51) Int. Cl.: H05H 1/46, C23C 16/505, H01L 21/205, H01L 21/3065, H01J 37/32

(54) **PLASMA PROCESSING DEVICE**
PLASMAVERARBEITUNGSVORRICHTUNG
APPAREIL DE TRAITEMENT AU PLASMA

(30) Priority: 11.03.2009 JP 2009057327
(43) Date of publication of application: 18.01.2012
(73) Proprietor: EMD Corporation, Shiga 520-2323 (JP); Tokyo Electron Limited, Tokyo 107-6325 (JP)
(72) Inventor: SETSUHARA, Yuichi, Suita-shi Osaka 565-0871 (JP); NISHIMURA, Eiichi, Nirasaki City Yamanashi 407-0192 (JP); EBE, Akinori, Kyoto-shi Kyoto 601-8355 (JP)
(74) Representative: Hehl, Ulrich
(86) International application number: PCT/JP2010/054017
(87) International publication number: WO 2010/104120

(56) References cited:
- EP-A1- 1 589 793
- EP-A1- 1 729 551
- EP-A2- 0 838 839
- JP-A- 6 283 473
- JP-A- 9 245 993
- JP-A- 10 233 297
- JP-A- 11 238 597
- JP-A- 2004 039 719
- JP-A- 2004 186 531
- JP-A- 2004 186 531
- JP-A- 2004 349 199
- JP-A- 2006 324 603
- JP-A- 2008 075 182
- US-A- 3 283 205
- US-A1- 2004 011 466

## Description

### TECHNICAL FIELD

The present invention relates to an inductively coupled plasma processing device that can be used for the surface processing of a base body or for other purposes.

### BACKGROUND ART

Inductively coupled plasma processing devices are widely used for the thin-film formation on or the etching process of the surface of a base body. In inductively coupled plasma processing devices, a plasma production gas, such as hydrogen gas, is introduced into a vacuum container, after which a radio-frequency electric field is induced to decompose the plasma production gas and thereby produce plasma. Subsequently, another kind of gas, which serves as a film-forming material gas or an etching gas, is introduced into the vacuum container. In the former case, the molecules of the film-forming material gas are decomposed by the plasma and deposited on a base body. In the latter case, the molecules of the etching gas are decomposed into ions or radicals for the etching process.

JP-A 8-227878 discloses a plasma processing device using an external antenna, in which a radio-frequency antenna for inducing a radio-frequency electric field is disposed above the ceiling of the vacuum container and the portion of the ceiling located directly below the radio-frequency antenna is made of a dielectric material serving as a window for allowing the passage of the induced radio-frequency electric field. In this external antenna type plasma processing device, when the device size is increased to deal with the recent increase in the size of the base body to be processed, it is necessary to increase the thickness of the dielectric window in order to maintain its mechanical strength, which results in a decrease in the strength of the radio-frequency electric field introduced into the vacuum container. Given this problem, an internal antenna type plasma processing device, in which the radio-frequency antenna is provided inside the vacuum container, has also been conventionally used (see JP-A 11-317299, JP-A 2001-035697 and JP-A 2004-039719).

The inventions described in JP-A 2001-035697 and JP-A 2004-039719 use a radio-frequency antenna consisting of a one-dimensional conductor that is terminated without completing one turn (which corresponds to an inductively coupled antenna with the number of turns less than one), such as a U-shaped or semicircular antenna. Such a radio-frequency antenna has an inductance lower than that of an inductively coupled antenna whose number of turns is equal to or greater than one. The lower inductance reduces the radio-frequency voltage occurring at both ends of the radio-frequency antenna and thereby suppresses radio-frequency fluctuation of the plasma potential due to electrostatic coupling to the generated plasma. As a result, an excessive loss of electrons to the ground potential due to the fluctuation of the plasma potential is decreased, whereby the plasma potential is decreased. Therefore, a film formation process with a low level of ion damage to the base body can be performed.

Furthermore, in an invention described in JP-A 2004-039719 , an antenna conductor is made to be shorter than one quarter of the wavelength of the radio-frequency waves. This design prevents the generation of standing waves in the antenna conductor and improves the uniformity of the generated plasma.

US2004/0011466A1 discloses a plasma processing apparatus generating plasma by supplying radio-frequency power. A radio-frequency antenna is disposed in the inside and outside of the process chamber so that the radio-frequency antenna is wound around the top plate of the process chamber. The antenna is protected by an insulating tube.

EP 1 589 793 A1 discloses a high frequency power supply device and plasma generator having a plurality of antennas generating a plasma in a vacuum chamber when supplied with a high frequency signal. The antennas are installed through a vacuum flange in a wall of the vacuum chamber.

EP 0 838 839 A2 discloses a plasma processing device with a coil arranged outside a dielectric window in the ceiling part of the chamber.

### DISCLOSURE OF THE INVENTION

### PROBLEM TO BE SOLVED BY THE INVENTION

In the internal antenna type plasma processing device, the ions in the plasma are accelerated toward the radio-frequency antenna by a self-bias DC voltage which occurs between the conductor of the radio-frequency antenna and the plasma. Therefore, if the antenna conductor is exposed, the conductor of the radio-frequency antenna itself undergoes sputtering, which shortens the life of the conductor. Furthermore, the atoms or ions sputtered from the conductor are mixed in the plasma and adhere to the surface of the base body being processed or the inner wall of the vacuum container, causing impurities to be mixed in the thin film being formed or the base body being etched. To address this problem, in the invention described in JP-A 11-317299, the radio-frequency antenna is sheathed in a pipe made of a dielectric (insulating) material, such as ceramic or quartz, which is less likely to be sputtered than the material of the radio-frequency antenna conductor, such as copper or aluminum. The reason for using a pipe is to supply cooling water for preventing an increase in the temperature of the antenna conductor. However, this configuration requires both an electrical connector for inputting a radio-frequency power and a connector for supplying or discharging the cooling water to be provided at the ends of the antenna conductor and the dielectric pipe. Such a structure will be complex, making it difficult to attach or detach the antenna or perform maintenance and inspection thereof.

In the internal antenna type, since the radio-frequency antenna protrudes into the internal space of the vacuum container, the plasma is produced in the vicinity of the radio-frequency antenna. Therefore, the plasma density particularly increases in the vicinity of the radio-frequency antenna and the density distribution becomes less uniform. Another problem is that the material of the thin film used in the film formation process or a by-product resulting from the etching process adheres to the surface of the radio-frequency antenna (or a dielectric pipe around this antenna). Such a material or by-product may fall onto the surface of the base body and form so-called particles.

Furthermore, as compared to the external antenna type, the internal antenna type needs a vacuum container having a larger capacity in order to ensure a space for the radio-frequency antenna within the vacuum container. Therefore, the gas or plasma easily diffuses, which decreases the amount of ions or radicals reaching the base body and lowers the film-formation rate or etching rate.

The problem to be solved by the present invention is to provide a plasma processing device capable of inducing a strong radio-frequency electric field within a vacuum container and improving the uniformity in the density distribution of the plasma, while preventing formation of particles or contamination of a base body due to the sputtering of the conductor of the radio-frequency antenna.

### MEANS FOR SOLVING THE PROBLEMS

A plasma processing device according to the present invention aimed at solving the aforementioned problem is an inductively coupled plasma processing device using a radio-frequency electric discharge according to claim 1.

In the plasma processing device according to the present invention, an antenna-placing section is provided between the inner and outer surfaces of the wall of the vacuum container. A radio-frequency antenna located in such an antenna-placing section is capable of inducing a radio-frequency electric field in the vacuum container with a strength comparable to that of the radio-frequency electric field created by an internal antenna type plasma processing device.

On the other hand, unlike the conventional internal antenna type, the radio-frequency antenna is separated from the internal space of the vacuum container by a dielectric separating member, whereby the formation of particles and the sputtering of the radio-frequency antenna are prevented. Furthermore, an increase in the temperature of the radio-frequency antenna is suppressed.

Since it is unnecessary to provide a space for placing the radio-frequency antenna within the vacuum container, the capacity of the vacuum container can be smaller than in the case of the internal antenna type. Therefore, the diffusion of the gas or plasma is suppressed, which increases the amount of ions or radicals reaching the base body and improves the film-formation rate or the etching rate.

Furthermore, the separation between the radio-frequency antenna and the plasma production space prevents the plasma density from being particularly high in the vicinity of the radio-frequency antenna. Therefore, unlike the internal antenna type, the uniformity in the density distribution will not deteriorate. The use of an antenna having a length equal to or shorter than one quarter of the wavelength of the radio-frequency waves is also effective for preventing the deterioration in the uniformity in the density distribution since no standing waves occur in such an antenna.

The separating member may be a dielectric member provided apart from the wall of the vacuum container. Alternatively, if the wall of the vacuum container is made of a dielectric material, a portion of the wall may be used as the separating member.

Although the radio-frequency antenna may be embedded in the wall, it is easier to place it in a hollow space formed between the aforementioned inner and outer surfaces. In the former case, the portion of the wall of the vacuum container in which the radio-frequency antenna is embedded corresponds to the antenna-placing section. In the latter case, the hollow space corresponds to the antenna-placing section.

The hollow space may be a hermetically closed space. This design prevents foreign matters from entering the hollow space. When this hollow space is in the vacuum state or filled with an inert gas, no unnecessary electric discharge occurs in the hollow space.

The hollow space may be filled with a solid dielectric material. This also prevents the occurrence of unnecessary electric discharge in the hollow space. In this case, it is unnecessary to hermetically close the hollow space. Instead of using the hollow space, it is possible to adopt the structure in which at least a portion of the wall is made of a solid dielectric and the radio-frequency antenna is embedded in the solid dielectric.

A cover may be provided on the outer-surface side of the hollow space. The use of such a cover facilitates maintenance, inspection or similar tasks; when the cover is opened, the radio-frequency antenna can be easily removed from the hollow space through the wall of the vacuum container to the outside and then set to the original position. Furthermore, the radio-frequency antenna may be fixed to the cover. In this case, users can more easily remove or set the radio-frequency antenna by merely detaching or attaching the cover.

The plasma processing device according to the present invention may be provided with a plurality of antenna-placing sections. This design further improves the uniformity in the density of the plasma created within the vacuum container.

### EFFECT OF THE INVENTION

The plasma processing device according to the present invention is capable of inducing a strong radio-frequency electric field within the vacuum container and improving the uniformity in the density distribution of the plasma, while preventing formation of particles or contamination of a base body due to the sputtering of the conductor of the radio-frequency antenna.

### BRIEF DESCRIPTION OF THE DRAWINGS

Fig. 1 is (a) a vertical sectional view of the first embodiment of the plasma processing device according to the present invention and (b) an enlarged view of an antenna-placing section 12 and surrounding components.
Fig. 2 is a top view showing one example of the connection between radio-frequency antennae and radio-frequency power sources.
Fig. 3 is an enlarged vertical sectional view of the second embodiment of the plasma processing device according to the present invention.
Fig. 4 is an enlarged vertical sectional view showing a first variation of the plasma processing device according to the second embodiment.
Fig. 5 is an enlarged vertical sectional view showing a second variation of the plasma processing device according to the second embodiment.
Fig. 6 is an enlarged vertical sectional view of the third embodiment of the plasma processing device according to the present invention.
Fig. 7 is a vertical sectional view showing an example in which the radio-frequency antenna is embedded between the outer surface 111A and the inner surface 111B.
Fig. 8 is a side view and a top view showing an example in which a plate-shaped member is used as a part of the radio-frequency antenna.
Fig. 9 is a graph showing the result of an experiment for investigating a change in the plasma density with changing output of the radio-frequency power.

### BEST MODE FOR CARRYING OUT THE INVENTION

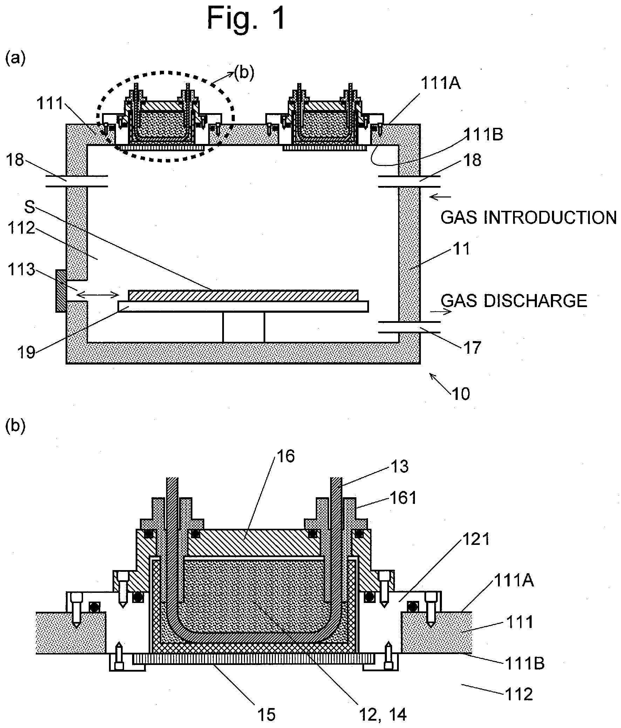

Embodiments of the plasma processing device according to the present invention are hereinafter described by means of Figs. 1-9.

### FIRST EMBODIMENT

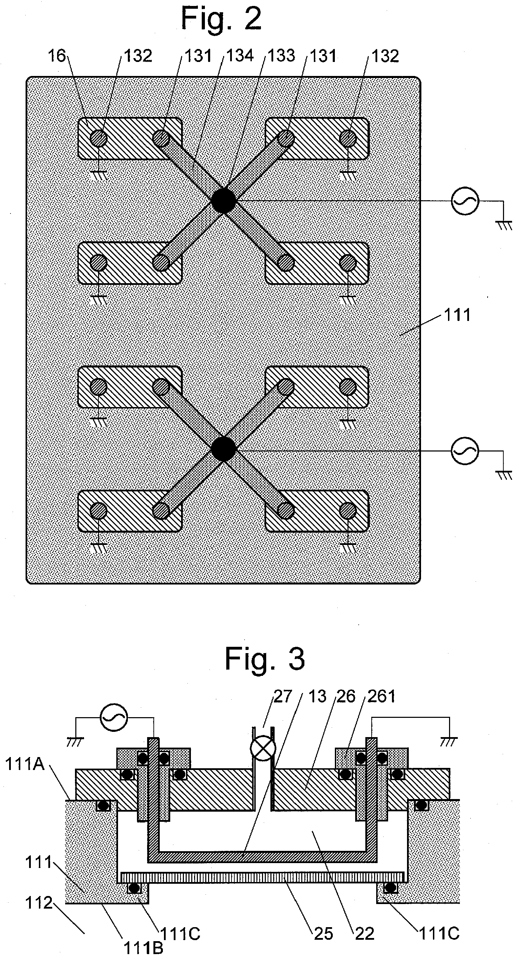

Initially, a plasma processing device 10 of the first embodiment is described by means of Figs. 1 and 2. The plasma processing device 10 includes a vacuum container 11, a plurality of antenna-placing sections 12 each of which is located between the outer surface 111A and the inner surface 111B of the top wall 111 of the vacuum container 11, a radio-frequency antenna 13 placed in each antenna-placing section 12, a dielectric filler 14 in the form of a mass filling the space around the radio-frequency antenna 13 in the antenna-placing section 12, a dielectric separating member (separating plate) 15 provided on the side of the antenna-placing section 12 facing the inner surface 111B of the top wall, a cover 16 for covering the antenna-placing section 12 on the outer surface 111A of the top wall, a gas discharge port 17 and gas introduction ports 18 provided in the side wall of the vacuum container 11, and a base-body holder 19 provide in the internal space 112 of the vacuum container.

Specifically, the antenna-placing section 12 is constructed as follows. A through-hole is formed in a portion of the top wall 111 of the vacuum container 11. A plate-shaped support member 121 is attached to the top wall 111, being fitted in the through-hole. The support member 121 has a hollow space bored from above. This space corresponds to the antenna-placing section 12. As described previously, the radio-frequency antenna 13 and the dielectric filler 14 are provided in the antenna-placing section 12. The cover 16 has its edge fixed to the upper side of the support member 121.

The radio-frequency antenna 13 is a U-shaped metal pipe. The length of this pipe is 35 cm. Many commercial radio-frequency power sources operate at a frequency of 13.56 MHz. The propagation wavelength of the radio-frequency waves having this frequency is 22 m in free space. However, according to a propagation model in which the coupling with plasma is considered, their propagation wavelength is estimated to be approximately 13 m (Yuichi SETSUHARA and Akinori EBE, "Plasma Technologies for Meters-scale Large-Area Processes", Journal of The Surface Finishing Society of Japan, The Surface Finishing Society of Japan, May 2005, Vol. 56, No. 5, pp. 18-25). Accordingly, the length of the aforementioned metal pipe is shorter than one quarter of the propagation wavelength of the 13.56-MHz waves. Both ends of the radio-frequency antenna 13 are fixed to the cover 16 via feedthroughs 161. The pipe of the radio-frequency antenna 13 functions as a channel through which a coolant (e.g. water) can be passed to cool the radio-frequency antenna 13 while the plasma processing device 10 is being used.

The separating member 15 is used for preventing the inside of the antenna-placing section 12 from being exposed to plasma. The separating member 15 will be exposed to plasma and hence should desirably be made of a material having high plasma resistance, such as quartz. On the other hand, the dielectric filler 14, which will not be exposed to plasma due to the presence of the separating member 15, should preferably be made of a material having high workability rather than high plasma resistance. Examples of such high-workability materials include polytetrafluoroethylene (PTFE), polyether ether ketone (PEEK) and other kinds of resin. Naturally, alumina, silica and other kinds of ceramics are also available.

Vacuum seals are provided between the top wall 111 and the support member 121, between the support member 121 and the cover 16, as well as between the cover 16 and the feedthrough 161, respectively. On the other hand, although the separating member 15 is attached to the support member 121, no vacuum seal is provided between the separating member 15 and the support member 121.

The gas discharge port 17 is connected to a vacuum pump. By this vacuum pump, the air, steam and other contents in the internal space 112 of the vacuum container are discharged through the gas discharge port 17. The gas introduction port 18 is used for introducing a plasma production gas (e.g. hydrogen gas) and a film-forming material gas into the internal space 112 of the vacuum container. The base body S to be held on the base-body holder 19 is loaded into the internal space 112 of the vacuum container or unloaded from the same space through a base-body transfer opening 113 formed in the side wall of the vacuum container 11. The base-body transfer opening 113 is hermetically closed except when the base body is loaded into or unloaded from the vacuum container.

One example of the connection between the radio-frequency antennae 13 and radio-frequency power sources is hereinafter described by means of Fig. 2. The device in accordance with the present embodiment uses a total of eight radio-frequency antennae 13 contained in eight antenna-placing sections 12, respectively. These eight radio-frequency antennae 13 are divided into two groups, each group including four antennae, and one radio-frequency power source is connected to each group. One end (power supply end 131) of each of the radio-frequency antennae 13 is connected to each of the four power supply rods 134 extending from a power supply point 133 in four directions, to which point the aforementioned radio-frequency power source is connected. The other end (grounded end 132) of each of the radio-frequency antennae 13 is connected to a ground.

As one example of the operation of the plasma processing device 10 of the present embodiment, the process of depositing a film-forming material on the base body S is hereinafter described. Initially, a base body S is loaded through the base-body transfer opening 113 into the internal space 112 of the vacuum container and placed onto the base-body holder 19. After the base-body transfer opening 113 is closed, the air, steam and other contents in the internal space 112 of the vacuum container are discharged through the gas discharge port 17 by using the vacuum pump. Subsequently, a plasma production gas and a film-forming material gas are introduced from the gas introduction port 18. A radio-frequency power is supplied to each radio-frequency antenna 13, while a coolant is passed through the pipe of the radio-frequency antenna 13. By this radio-frequency power supply, a radio-frequency electric field is induced around the radio-frequency antenna 13. This radio-frequency electric field is introduced through the dielectric separating member 15 into the internal space 112 of the vacuum container and ionizes the plasma production gas, whereby plasma is produced. The film-forming material gas, which has been introduced into the internal space 112 of the vacuum container together with the plasma production gas, is decomposed by the resultant plasma, to be deposited on the base body S.

As compared to the external antenna type, the plasma processing device 10 of the present embodiment can create a stronger radio-frequency electric field within the internal space 112 of the vacuum container 11 since the radio-frequency antenna 13 is located in the antenna-placing section 12 provided between the outer surface 111A and the inner surface 111B of the top wall 111 of the vacuum container. Furthermore, since the antenna-placing section 12 including the radio-frequency antenna 13 is separated from the internal space 112 of the vacuum container by the separating member 15, the plasma produced in the aforementioned space is prevented from etching the radio-frequency antenna 13 and shortening its life, or the material of the radio-frequency antenna 13 is prevented from being an impurity and mixed in the film being formed or the base body being processed. The dielectric filler 14 in the antenna-placing section 12 prevents unnecessary electric discharge from occurring in the antenna-placing section 12.

In the first embodiment, the dielectric separating member (separating plate) 15 is provided apart from the dielectric filler 14. If the dielectric filler 14 is made of a material with high plasma resistance, and if a sufficiently thick layer of the dielectric filler 14 is present between the internal space 112 of the vacuum container and the radio-frequency antenna 13, it is possible to omit the separating member 15 (provided apart from the dielectric filler 14) since the aforementioned layer of the dielectric filler 14 functions as the separating member.

The dielectric filler 14 used in the first embodiment is in the form of a mass. Alternatively, a dielectric powder may be used, in which case the antenna-placing section 12 should be hermetically closed so that the powder will not leak from the antenna-placing section 12.

### SECOND EMBODIMENT

A plasma processing device of the second embodiment is hereinafter described by means of Fig. 3. In the following description, the components identical to those used in the plasma processing device 10 of the first embodiment are denoted in Fig. 3 by the same numerals as used in Fig. 1 and will not be specifically described. One feature of the present embodiment is that a hollow space 22 serving as the antenna-placing section is formed between the outer surface 111A and the inner surface 111B of the top wall 111 of the vacuum container 11.

A dielectric separating member 25 is provided on the side of the inner surface 111B of the hollow space 22, while a cover 26 is provided on the side of the outer surface 111A. The separating member 25 is attached to the wall in such a manner that it is mounted on a step 111C protruding inwards from the lower end of the inner circumferential surface of the hollow space 22. The cover 26 has a projecting portion on its lower surface so that it can fit in the hollow space 22 from the outer side of the vacuum container 11. Both ends of the radio-frequency antenna 13 are fixed to the cover 26 via the feedthroughs 261. The radio-frequency antenna 13 can be easily detached from or attached to the plasma processing device by detaching or attaching the cover 26.

The hollow space 22 is hermetically sealed with vacuum seals provided between the cover 26 and the top wall 111 as well as between the separating member 25 and the top wall 111. The cover 26 is provided with a hollow-space exhaust port 27 so that the hollow space 22 can be evacuated independently of the internal space 112 of the vacuum container.

The operation of the plasma processing device of the second embodiment is basically the same as that of the plasma processing device 10 of the first embodiment. An important difference is that the hollow space 22 is evacuated by discharging the gas in the hollow space 22 through the hollow-space exhaust port 27 to the outside before the radio-frequency power is supplied to the radio-frequency antenna 13. This prevents unnecessary electric discharge from occurring in the hollow space 22.

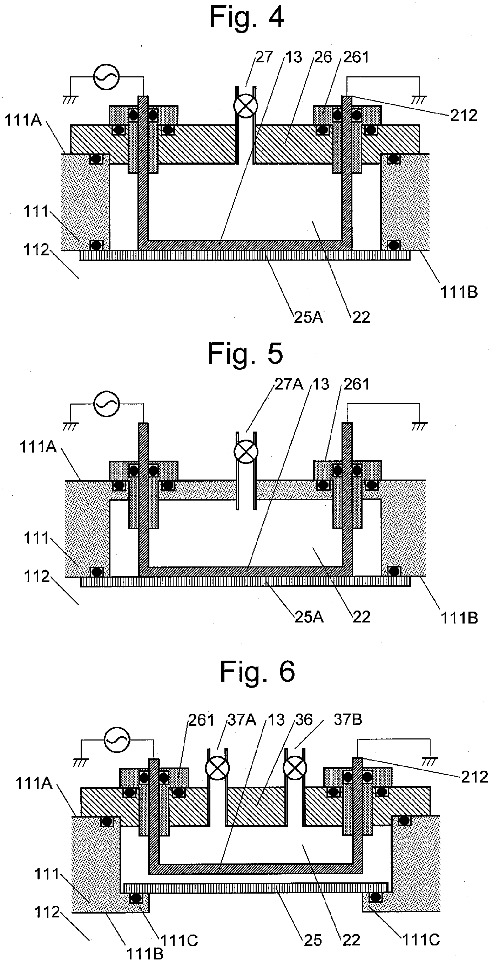

A first variation of the second embodiment is hereinafter described by means of Fig. 4. In the present variation, the device has no step 111C; the separating member 25A is arranged so that it covers the hollow space 22 on the side facing the internal space 112 of the vacuum container. With this design, the hollow space 22 is expanded toward the internal space 112 of the vacuum container and the radio-frequency antenna 13 can be brought closer to the internal space 112 of the vacuum container. The other structural elements are the same as those of the second embodiment.

A second variation of the second embodiment is hereinafter described by means of Fig. 5. In the present variation, a hollow space 22A is created by boring a hole from the lower surface of the top wall 111 without completely penetrating through the top wall 111. Accordingly, a portion of the top wall 111 remains intact above the hollow space 22A. The radio-frequency antenna 13 is fixed to this remaining portion of the top wall 111 via feedthroughs. The hollow-space exhaust port 27A is also provided in that portion of the top wall 111. The other structural elements are the same as those of the first variation of the second embodiment.

### THIRD EMBODIMENT

The plasma processing device of the third embodiment is hereinafter described by means of Fig. 6. In the present embodiment, a hollow-space inert-gas introduction port 37A and a hollow-space gas discharge port 37B are provided in the cover 36 in place of the hollow-space exhaust port 27 in the second embodiment. The hollow space 22 can be filled with an inert gas, such as argon or nitrogen, by introducing the inert gas through the hollow-space inert-gas introduction port 37A to replace air and steam in the hollow space 22 by the inert gas and discharge the air and steam through the hollow-space gas discharge port 37B to the outside. As a result, similar to the case of evacuating the hollow space 22, the occurrence of unnecessary electric discharge is prevented. The other structural elements are the same as those of the second embodiment.

### FOURTH EMBODIMENT

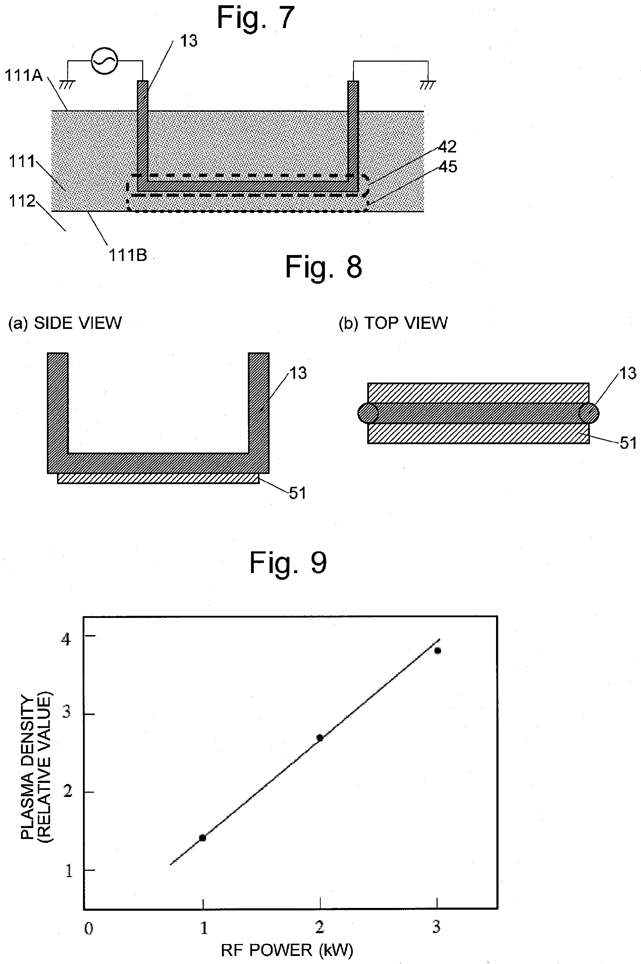

In any of the previously described examples, the dielectric filler 14 or hollow space 22 was located between the outer surface 111A and the inner surface 111B of the vacuum container. However, it is possible to embed the radio-frequency antenna 13 between the outer surface 111A and the inner surface 111B without using any hollow space, as shown in Fig. 7, where the region denoted by numeral 42 corresponds to the antenna-placing section. In this case, in order to electrically insulate the radio-frequency antenna 13 from the top wall 111 and to prevent unnecessary electric discharge from occurring in the vicinity of the radio-frequency antenna 13, a dielectric member should be provided between the radio-frequency antenna 13 and the top wall 111, or the top wall 111 should be made of a dielectric material. In the latter case, the top wall 111 may be entirely made of the dielectric material. However, for the sake of the cost reduction, it is preferable to use the dielectric material only in the portion of the top wall 11 near the radio-frequency antenna 13. For the herein mentioned dielectric material, the previously listed materials of the dielectric filler 14 are similarly available. The portion of the top wall 111 located between the radio-frequency antenna 13 and the internal space 112 of the vacuum container may be made of a dielectric material so that this portion functions as a separating plate 45.

### [Variation Common to Previous Embodiments]

In any of the previous embodiments, the rod-shaped (tubular) radio-frequency antenna may be replaced with a plate-shaped radio-frequency antenna or a composite radio-frequency antenna including a rod-shaped member combined with a plate-shaped member. By appropriately selecting a rod-shaped antenna or a plate-shaped antenna or combining the two types of antenna, it is possible to adjust the impedance of the antenna. Fig. 8 shows a radio-frequency antenna including a U-shaped metal pipe with a flat bottom face to which a plate-shaped member 51 is attached. The impedance of this antenna can be adjusted by changing the width and/or thickness of the plate-shaped member 51.

In place of the U-shaped radio-frequency antenna used in the previous embodiments, a radio-frequency antenna having a semicircular shape, arc shape or the like may be used. The semicircular or arc-shaped radio-frequency antenna is an inductively coupled antenna whose number of turns is less than one. The inductance of such an antenna is lower than that of an antenna whose number of turns is equal to or greater than one. Therefore, the voltage which occurs in the antenna when a predetermined radio-frequency power is supplied is low, so that plasma can be efficiently produced. The number of antenna-placing sections, which was eight in the previous embodiments, can be appropriately determined according to the capacity of the vacuum container or other factors. Using only one antenna-placing section may be sufficient for a vacuum container having a rather small capacity. Unlike the previous embodiments, in which the antenna-placing section was provided in the top wall of the vacuum container, the antenna-placing section may be provided in a different wall, such as the side wall.

### [First Experiment]

For a plasma processing device according to the second embodiment with only one antenna-placing section, the density of the plasma produced within the vacuum container was measured. A U-shaped copper pipe of 6 mm in outer diameter with a bottom section extending parallel to the top wall 111 over a length of 150 mm was used the radio-frequency antenna 13. The position of the bottom section of the radio-frequency antenna 13 was adjusted to be level with the inner wall surface of the top wall 111 (Fig. 4). A quartz plate of 6 mm in thickness was used as the separating member 25A.

After the vacuum container 11 was evacuated, a mixture gas of hydrogen and argon was introduced into the vacuum container 11 to a pressure of 1 Pa. Subsequently, a radio-frequency power of 1 kW in output and 13.56 MHz in frequency was supplied to the radio-frequency antenna 13 while cooling water was supplied through the antenna pipe. As a result, the vacuum container 11 became filled with plasma. The plasma density at a point located 20 cm away from the bottom section of the U-shaped radio-frequency antenna 13 was 1.2x10¹¹/cm³. When the output of the radio-frequency power was varied within the range from 1 kW to 3 kW, the plasma density at the aforementioned point changed in proportion to the output of the radio-frequency power (Fig. 9).

### [Second Experiment]

A copper plate of 150 mm in length and 30 mm in width, being held parallel to the top wall 111, was attached to the bottom section of the radio-frequency antenna 13 used in the first experiment. As compared to the first experiment, the position of the radio-frequency antenna 13 was shifted upwards so as to level the copper plate with the lower surface of the top wall 111. Using this radio-frequency antenna, an experiment similar to the first experiment was performed. The plasma density at a point located 20 cm away from the copper plate was 1.4x10¹¹/cm³, which was higher than in the first experiment with no copper plate used. This is probably because the electric current flowing through the radio-frequency antenna (the copper pipe and the copper plate) increased due to a decrease in the impedance of the antenna caused by attaching the copper plate having a width larger than the diameter of the copper pipe.

For comparison, the same experiment was performed with the separating member 15A removed. The result was that the plasma density at the aforementioned point was 1.6x10¹¹/cm³. Thus, it was confirmed that the use of the separating member 25A has only a minor effect on the production of plasma.

### [Third Experiment]

Eight sets of the radio-frequency antennas used in the first experiment were connected as shown in Fig. 2, and a radio-frequency power of 2 kW in output and 13.56 MHz in frequency were supplied to each power supply point 133. The other conditions were the same as in the first and second experiments. For each radio-frequency antenna unit, the plasma density at a point located 20 cm away from the bottom section of the U-shaped radio-frequency antenna 13 was measured. The result confirmed that a cloud of plasma having approximately the same strength was produced by any of the radio-frequency antennas. This result suggests that it is possible to improve the uniformity of the plasma within the vacuum container 11 by using a plurality of radio-frequency antennas (or antenna-placing sections including the radio-frequency antennas) each of which produces plasma having approximately the same strength.

### EXPLANATION OF NUMERALS

- 10...: Plasma Processing Device
- 11...: Vacuum Container
- 111...: Top Wall of Vacuum Container 11
- 111A...: Outer Surface of Top Wall 111
- 111B...: Inner Surface of Top Wall 111
- 111C...: Step of Inner Surface 111B
- 112...: Internal Space
- 113...: Base-Body Transfer Opening
- 12, 42...: Antenna-Placing Section
- 121...: Support Member
- 13...: Radio-Frequency Antenna
- 131...: Power Supply End
- 132...: Grounded End
- 133...: Power Supply Point
- 134...: Power Supply Rod
- 14...: Dielectric Filler
- 15, 15A, 25, 25A, 45...: Separating Member
- 16, 26, 36...: Cover
- 161, 261...: Feedthrough
- 17...: Gas Discharge Port
- 18...: Gas Introduction Port
- 19...: Base-Body Holder
- 22, 22A...: Hollow Space
- 27, 27A...: Hollow-Space Exhaust Port
- 37A...: Hollow-Space Inert-Gas Introduction Port
- 37B...: Hollow-Space Gas Discharge Port
- 51...: Plate-Shaped Member
- S...: Base Body

## Claims

1. An inductively coupled plasma processing device (10) using a radio-frequency electric discharge, comprising:
a vacuum container (11) having a wall (111);
a radio-frequency antenna (13), the radio-frequency antenna (13) being terminated without completing one turn;
wherein a radio-frequency power which induces radio-frequency waves with a propagation wavelength is supplied to the radio-frequency antenna (13) from a radio-frequency power source;
wherein the radio-frequency antenna (13) has a length equal to or shorter than one quarter of the wavelength;
**characterized in that**
an antenna-placing section (12) is formed as a hollow space (22) between an inner surface (111B) and an outer surface (111A) of the wall (111);
a dielectric separating member (15) having a plate-like shape is provided on the inner-surface side of the hollow space (22) for separating the antenna-placing section (12) from an internal space (112) of the vacuum container (11) and preventing the inside of the antenna-placing section (12) from being exposed to a plasma in the vacuum container (11);
the radio-frequency antenna (13) is placed in the antenna-placing section (12); and
a cover (16) is provided on the outer-surface side of the hollow space (22).

2. The plasma processing device (10) according to claim 1, wherein the hollow space (22) is hermetically closed by the cover (16).

3. The plasma processing device (10) according to claim 1 or 2, wherein the hollow space (22) is filled with a solid dielectric material (14).

4. The plasma processing device (10) according to claim 1 or 2, wherein the hollow space (22) is filled with an inert gas.

5. The plasma processing device (10) according to one of the preceding claims, wherein the radio-frequency antenna (13) is fixed to the cover (16).

6. The plasma processing device (10) according to one of the preceding claims, wherein the radio-frequency antenna (13) is U-shaped.

7. The plasma processing device according to one of the preceding claims, comprising a plurality of the antenna-placing sections (12).

## Patentansprüche

1. Induktive Plasmaverarbeitungsvorrichtung (10) mit elektrischer Hochfrequenzentladung, die Folgendes aufweist:
einen Vakuumbehälter (11) mit einer Wand (111),
eine Hochfrequenzantenne (13), wobei die Hochfrequenzantenne (13) ohne Vollendung einer Wicklung abgeschlossen ist,
wobei der Hochfrequenzantenne (13) von einer Hochfrequenzversorgung eine Hochfrequenzleistung zugeführt ist, die Hochfrequenzwellen mit einer Ausbreitungswellenlänge aufweist,
wobei die Hochfrequenzantenne (13) eine Länge gleich einem oder kürzer als ein Viertel der Wellenlänge aufweist,
**dadurch gekennzeichnet,**
**dass** ein Antennenaufnahmeabschnitt (12) als Hohlraum (22) zwischen einer Innenfläche (111B) und einer Außenfläche (111A) der Wand (111) ausgebildet ist,
**dass** ein dielektrisches Trennelement (15) mit plattenartiger Form auf der inneren Seite des Hohlraums (22) vorgesehen ist, um den Antennenaufnahmeabschnitt (12) von einem Innenraum (112) des Vakuumbehälters (11) zu trennen und zu verhindern, dass das Innere des Antennenaufnahmeabschnitts (12) dem Plasma in dem Vakuumbehälter (11) ausgesetzt ist,
**dass** die Hochfrequenzantenne (13) in dem Antennenaufnahmeabschnitt (12) angeordnet ist und
**dass** eine Abdeckung (16) auf der äußeren Seite des Hohlraums (22) vorgesehen ist.

2. Plasmaverarbeitungsvorrichtung (10) nach Anspruch 1, wobei der Hohlraum (22) durch die Abdeckung (16) hermetisch abgedichtet ist.

3. Plasmaverarbeitungsvorrichtung (10) nach Anspruch 1 oder 2, wobei der Hohlraum (22) mit einem festen dielektrischen Material (14) gefüllt ist.

4. Plasmaverarbeitungsvorrichtung (10) nach Anspruch 1 oder 2, wobei der Hohlraum (22) mit einem Inertgas gefüllt ist.

5. Plasmaverarbeitungsvorrichtung(10) nach einem der vorhergehenden Ansprüche, wobei die Hochfrequenzantenne (13) an der Abdeckung (16) befestigt ist.

6. Plasmaverarbeitungsvorrichtung (10) nach einem der vorhergehenden Ansprüche, wobei die Hochfrequenzantenne (13) U-förmig ist.

7. Plasmaverarbeitungsvorrichtung (10) nach einem der vorhergehenden Ansprüche, die eine Vielzahl von Antennenaufnahmeabschnitten (12) aufweist.

## Revendications

1. Appareil de traitement au plasma à couplage inductif (10) utilisant une décharge électrique radiofréquence, comprenant :
un récipient sous vide (11) ayant une paroi (111) ;
une antenne radiofréquence (13), l'antenne radiofréquence (13) étant terminée sans achever une spire ;
dans lequel une puissance radiofréquence qui induit des ondes radiofréquences ayant une longueur d'onde de propagation, est fournie à l'antenne radiofréquence (13) depuis une source de puissance radiofréquence ;
dans lequel l'antenne radiofréquence (13) présente une longueur égale ou inférieure à un quart de la longueur d'onde ;
**caractérisé en ce que**
une section de mise en place d'antenne (12) est formée sous la forme d'un espace creux (22) entre une surface interne (111B) et une surface externe (11A) de la paroi (111) ;
un élément de séparation diélectrique (15) en forme de plaque est disposé côté surface interne de l'espace creux (22) pour séparer la section de mise en place d'antenne (12) d'un espace interne (112) du récipient sous vide (11) et empêcher la partie intérieure de la section de mise en place d'antenne (12) d'être exposée à un plasma dans le récipient sous vide (11) ;
l'antenne radiofréquence (13) est placée dans la section de mise en place d'antenne (12) ; et
un couvercle (16) est disposé côté surface externe de l'espace creux (22).

2. Appareil de traitement au plasma (10) selon la revendication 1, dans lequel l'espace creux (22) est fermé hermétiquement par le couvercle (16).

3. Appareil de traitement au plasma (10) selon la revendication 1 ou 2, dans lequel l'espace creux (22) est rempli avec un matériau diélectrique solide (14).

4. Appareil de traitement au plasma (10) selon la revendication 1 ou 2, dans lequel l'espace creux (22) est rempli avec un gaz inerte.

5. Appareil de traitement au plasma (10) selon l'une quelconque des revendications précédentes, dans lequel l'antenne radiofréquence (13) est fixée au couvercle (16).

6. Appareil de traitement au plasma (10) selon l'une quelconque des revendications précédentes, dans lequel l'antenne radiofréquence (13) se présente sous la forme d'un U.

7. Appareil de traitement au plasma selon l'une quelconque des revendications précédentes, comprenant une pluralité de sections de mise en place d'antenne (12).
